# EUROPEAN PATENT SPECIFICATION

(11) **EP 4 490 780 B1**
(45) Date of publication and mention of the grant of the patent: **14.05.2025**
(21) Application number: 24713379.6
(22) Date of filing: 31.01.2024
(51) Int. Cl.: H01L 23/62, H01L 23/00, H01L 25/07, H01L 23/498, H01L 25/16, H01L 23/36, H01L 23/538, H01L 23/60, H01L 23/373

(54) **POWER MODULE FOR SOLID-STATE CIRCUIT BREAKER**
LEISTUNGSMODUL FÜR FESTKÖRPER-LEISTUNGSSCHUTZSCHALTER
MODULE DE PUISSANCE POUR DISJONCTEUR À L'ÉTAT SOLIDE

(30) Priority: 31.01.2023 CZ 20230041
(43) Date of publication of application: 15.01.2025
(73) Proprietor: Západoceská univerzita v Plzni, 301 00 Plzen (CZ)
(72) Inventor: PEROUTKA, Zdenek, 31200 Plzen (CZ); JARA, Martin, 30100 Plzen (CZ); REBOUN, Jan, 33701 Rokycany (CZ)
(74) Representative: Zmeskal, Lukas
(86) International application number: PCT/CZ2024/050005
(87) International publication number: WO 2024/160308

(56) References cited:
- WO-A1-2022/056679
- WO-A1-2022/189241
- US-A1- 2011 297 964
- US-A1- 2016 056 132
- US-A1- 2021 226 441
- US-A1- 2023 215 788

## Description

### Field of the invention

The present invention relates to a power module for solid-state circuit breakers. The power module comprises a power electronics circuit and non-power electronics devices, which provide an appropriate method for control of the power module components.

### Background of the invention

The fully solid-state circuit breakers belong to the technical field currently undergoing intense development, especially in the field of DC electrical circuits. This is related to a massive deployment of DC energy storages, DC distribution grids, and, last but not least, the expansion of the battery-supplied higher power applications. Here, the direct current protections and related circuit breakers improve the level of operation safety.

The fully solid-state DC circuit breaker is characterized by an absence of a mechanical switching apparatus. The function is conducted by a power electronics circuit with self-commutating power semiconductor devices, usually IGBT or MOSFET-type transistors that provide safe current tripping according to tripping characteristics of the circuit breaker.

Generally known topologies of the power electronics circuit for direct current tripping in both directions include, among others, a bridge rectifier with one transistor switch, an anti-serial connection of reverse conducting transistor switches, or an anti-parallel connection of reverse blocking transistor switches. Considering the required high nominal currents of the fully solid-state circuit breakers, it is necessary to arrange a certain number of transistors in parallel within one switch in order to achieve acceptable thermal loss under circuit breaker operation.

Document US2020/0365346 discloses a simple arrangement of a solid-state circuit breaker, to which a mechanical apparatus may be added, if galvanic load insulation is required for safety reasons. In this case the controlling section of the circuit breaker should provide a proper sequence of turning on and off both the mechanical apparatus and a power electronics circuit so that no current is loaded onto the mechanical apparatus upon turning on and tripping the circuit breaker. A controlling section shall also provide a proper control sequence when the circuit breaker is turned off manually. The power electronics circuit having bi-directional current tripping may be used in the circuit breaker not only to disconnect the load, i.e., to disconnect electrically conductive paths between mains input terminals and output terminals for a protected device, but it may also be used when circuit breaker tripping to produce an electrically conductive path between the mains input terminals. As disclosed in document US2021/0226441, the grid current flowing through this path causes the tripping of the superior protective device.

A power electronics circuit of a circuit breaker may be provided with discrete power semiconductor devices. The power electronic circuit may also be included in a power semiconductor module. Its structural components include a supporting base that provides a mechanical support to electronic components and permits dissipation of heat caused by power losses. Further included are electronic components for switching and creating a current pathway for a protected circuit, and electrically conductive patterns being created on at least one of the base surfaces and used for electrically conductive connection between the electronic components. For example, this solution is disclosed in document WO2009127179A1.

A common method for implementation of the power modules is use of the DBC technology. It is based on a ceramic substrate made from a material having high thermal conductivity while also providing electrical insulation. The substrate is provided with a copper layer fixed thereto using eutectic Cu and CuO₂ alloy on both sides. An electrically conductive pattern is etched in the copper layer. Etching of the pattern has a disadvantage with respect to wasting of materials, speed, and production safety. In addition, the etching method does not allow to achieve fine electrically conductive patterns. For example, this solution is disclosed in document KR20130139011A.

The ceramic substrate of the DBC technology may be layered by soldering to create sandwich structures. The power semiconductor bare dies may themselves be placed in a recess in the copper layer on a small ceramic substrate either individually or in small groups in a way to level up the upper side of the semiconductor bare die with the top side of the copper layer of the ceramic substrate. The bottom bare die electrode may be electrically connected to the lower side of the ceramic substrate via a passage in the ceramic substrate filled with a conductive material. The passage may be then used as a shunt resistor to measure the electric current. Each substrate may be put on a big ceramic substrate with the DBC technology according to requirements for total electric connection. Again, the need to use the copper layer thicker than thickness of the semiconductor bare die does not allow to achieve fine electrically conductive patterns, and the semiconductor bare dies fitted out like this do not use full surface of the ceramic substrate. For example, this solution is disclosed in document US2007/0138651.

Due to the high degree of parallelization of the transistors in the switch within the power electronics circuit topology of the circuit breaker, it is necessary to ensure optimum driving conditions (design symmetry, identical electrical parameters, minimization of parasitic inductances, etc.) for each individual transistor. Generally known approaches use non-power electronics devices very close to each transistor connected in parallel so that the impact of parasite elements in the commutation loop of the driving circuit is attenuated, in particular in dynamic phenomena in the power circuit.

Small dimensions of the non-power electronics devices require sufficiently fine electrically conductive pattern to be created correctly. The latter in a power module with a common substrate may not be feasible with etch-based technologies as the use of thick layers in the power circuit is required. In addition, the placement of the non-power electronics devices onto the same substrate with the power circuit limits the usable area of the power module surface for the electrically conductive patterns of the power circuit. This contributes to the increase of current density and power losses in the electrically conductive pattern of the power circuit. Also, the reduced surface of the electrically conductive pattern of the power circuit increases the power module's thermal resistance and the power module's internal operating temperature is increased thereby.

Document US2011/297964 discloses a power module for a solid-state circuit breaker comprising an insulating material in which there is arranged a bi-directional power electronics switch and non-power electronics circuits with protective elements, circuits controlling the power electronics switch and sensor circuits, further comprising a heat sink made of a dielectric material having thermal conductivity over 20 W/m/K, having on its surface an electrically conductive power pattern made of copper, wherein the electrically conductive power pattern comprises at least two electrically insulated sections, the bi-directional power electronics switch comprising power semiconductor bare dies mutually interconnected with a power conductive connection is placed on the electrically conductive power pattern and connected by the electrically conductive power connection, wherein the power electronics switch is positioned on longitudinal axis of the module, the electrically conductive power pattern is interconnected with output power electric terminals, the non-power electronics circuits are interconnected with output non-power electric terminals and with the power electronics switch via a non-power conductive connection, the output non-power electric terminals are interconnected with the protective circuits, wherein at least the heat sink, the power electronics switch, and the non-power electronics circuits are jointly included in a monolithic multilayer structure, which parts are connected through entire contact surfaces.

Document WO2022/189241 discloses a power module, in particular a commutation cell for an inverter. The power module has a ceramic circuit carrier and at least one semiconductor switch half-bridge having two semiconductor switches which are connected to the circuit carrier. The power module has a flexible printed circuit board which is connected to the circuit carrier in the region of the semiconductor switches. The power module has a temperature sensor which is connected to the flexible printed circuit board and is designed and arranged to capture a temperature of the circuit carrier in the region of the semiconductor switches.

Document US2016/056132 discloses a circuit arrangement including at least two semiconductor chips having first and second mutually connected load terminals, a first load current collecting conductor track, and an external terminal connected thereto. For each of the semiconductor chips, there is at least one electrical connection conductor connected to the first load terminal of the relevant semiconductor chip and also to the first load current collecting conductor track. The total inductance of all the connection conductors with which the first load terminal of the second of the semiconductor chips is connected to the first load current collecting conductor track has at least twice the inductance of that section of the first load current collecting conductor track which is formed between the second connection location of the first of the semiconductor chips and the second connection location of the second of the semiconductor chips.

Document US2021/226441 discloses a circuit interrupter device including line hot, line neutral, load hot, and load neutral terminals, a solid-state switch, internal short-circuit switch circuitry, and control circuitry. The solid-state switch is connected in an electrical path between the line hot and load hot terminals. The internal short-circuit switch circuitry comprises an internal short-circuit switch and a shunt resistor serially connected between the line hot and line neutral terminals. The control circuitry is configured to detect for an occurrence of a fault condition. In response to detecting the occurrence of a fault condition, the control circuitry is configured to drive the solid-state switch into a switched-off state, and activate the internal short-circuit switch to generate an internal short-circuit path between the line hot and line neutral terminals and allow short-circuit current to flow through the shunt resistor between the line hot terminal and the line neutral terminal of the circuit interrupter device.

The object of the present invention is to provide a power module for the fully solid-state circuit breakers, which allows power loss (heat) dissipation to the maximum extent from the power circuit components, allows implementation of excellent construction design symmetry of the power circuit, contains non-power electronics devices for optimum driving conditions and protection of the power electronics switches, and which may be manufactured without etching with maximum level of details of electrically conductive patterns by the thick printed copper layer method known as TPC.

### Summary of the invention

The present invention relates to the construction design of a power module for a solid-state circuit breaker. The module includes an insulating material in which at least bi-directional power electronics switch and non-power electronics circuits are arranged. The insulating material may be placed in a package. Alternatively, the insulating material may be self-supporting and its surface operates as the package, or the material itself is the package. The function of the package is known in the art, and it includes in particular mechanical durability (impact resistance, abrasion resistance) and resistance to environmental influences. The insulating material is preferably a dielectric potting material.

The non-power electronics circuits include at least protective elements, circuits controlling the power electronics switch and circuits of the sensors. In addition, the module includes a dielectric material heat sink having thermal conductivity over 20 W/m/K. It can be made, for example, of aluminium nitride or other suitable ceramics with suitable thermal conductivity and expansion properties. The electrically conductive power pattern of copper, silver, or combination thereof, is applied directly on the heat sink and comprises at least two electrically insulated sections, and it is applied preferably using a method of additive deposition.

The bi-directional power electronics switch is placed on the electrically conductive power pattern and connected by an electrically conductive power connection. The power electronics switch comprises non-encapsulated power semiconductor bare dies mutually interconnected by a power conductive connection. The power electronics switch is located on longitudinal axis of the module. Favourably, the power electronics switch is placed in the exact centre; however, a small deviation defined by the fit-out width of the power electronics switch causes no significant deterioration of the properties. The centric mounting of the power electronics switch results in optimum use of the die area and minimized inductance of a commutation loop. The dies of the power electronics switch may be mounted either by soldering or sintering.

The electrically conductive power pattern is interconnected with output power electric terminals. Furthermore, the electrically conductive power pattern is interconnected with auxiliary dielectric substrates through a contact layer. There are electrically conductive non-power patterns of silver, copper, or combination thereof, placed on the auxiliary dielectric substrates to interconnect the non-power electronics circuits. Favourably, the non-power electric patterns are applied by additive technology. The non-power electronics circuits are interconnected with the output non-power electric terminals and with the power electronics switch via the non-power conductive connection.

Both the output power electric terminals and the output non-power electric terminals may be embodied as soldering pins, press-fit pins, or ultrasound-welded electrodes. The output power electric terminals and the output non-power electric terminals are conductively connected with the protective circuits (e.g., by soldering). In particular, the protective circuits protect against overheating of the module. In addition, hazardous overvoltage occurs upon turning the power electronics switch off, which is managed using the protective circuits as well (overvoltage protection). The protective circuits may comprise a varistor (MOV), or TVS, or an active overvoltage circuit.

Favourably, the protective circuits are placed on their own substrate and it may be a ceramic-based one. It may be a printed circuit board based on a glass-epoxide material. Favourably, the substrate is placed above the power electronics switch and forms a sandwich arrangement having a minimum commutation loop. Said structure may be implemented to create a fully integrated power module for a solid-state circuit breaker. Alternatively, the protective circuits may be located outside the power module. However, the fully integrated design of the circuit breaker is not attainable in this case.

At least the heat sink, the power electronics switch, the auxiliary dielectric substrates, and the non-power electronics circuits are jointly included in a monolithic multilayer structure, elements of which are connected through entire contact surfaces. The contact surfaces between the components are desirably continuous and flat so that they fit together well for efficient heat transfer.

For more efficient cooling of the power module, the heat sink may be mechanically and heat-conductively connected with an auxiliary heat sink made of electrically conductive material having heat conductivity over 180 W/m/K. The auxiliary heat sink may be made of aluminium, copper, or other metal or metal alloy. A contact layer eligible to compensate differential thermal expansivity properties of the heat sink and of the auxiliary heat sink is made as a connection.

The contact layer of the heat sink may be a multilayer one. The layer may comprise an electrically conductive layer applied on the heat sink, and an electrically conductive connection of which full contact surfaces interconnect the electrically conductive layer and the auxiliary heat sink in a monolithic way.

Analogically, according to the claimed invention, the contact layer of the auxiliary dielectric substrate is a multilayer.

The layer comprises an electrically conductive layer applied on the auxiliary dielectric substrate, and electrically conductive power connection of which full contact surfaces interconnect the electrically conductive layer and the electrically conductive power pattern in a monolithic way.

A dielectric material of which the heat sink and/or auxiliary dielectric substrates are made, may be ceramics in particular. The electrically conductive power connection on the electrically conductive power pattern and/or electrically conductive connection of the auxiliary heat sink may be in particular a solder layer or a sintered material layer.

Favourably, the power electronics switch may be embodied either as comprising power semiconductor bare dies arranged in anti-serial order with reverse conducting transistor switches, or in an anti-parallel arrangement of reverse blocking transistor.

The power conductive connection between the power semiconductor bare dies of the bi-directional switch and/or the non-power conductive connection between the power semiconductor bare dies of the bi-directional switch and the non-power electronics circuit may comprise aluminium and/or copper wires and/or electrically conductive ribbons.

The object as defined above is achieved by the use of auxiliary substrates within the power module according to the present invention. The use of the auxiliary substrates will allow axially symmetrical arrangement because the conductive patterns for the transistor control and parameters sensing are made in above-crossing way.

### Explanation of drawings

The exemplary embodiment of the proposed invention is described with reference to the drawings, in which
Fig. 1 shows a cross-section view of a power module for fully solid-state circuit breaker with a heat sink made of a dielectric material;
Fig. 2 shows a cross-section view of a power module for fully solid-state circuit breaker with an auxiliary heat sink made of an electrically conductive material;
Fig. 3 shows layout of power module components on a heat sink - top view;
Fig. 4 shows placement of protective circuits on a substrate over a power electronics switch and non-power electronics circuits - top view.

### Exemplary embodiment of the invention

It is understood that specific embodiments of the invention described below are indicative only and do not in any way limit the embodiments of the invention to these specific ones shown here.

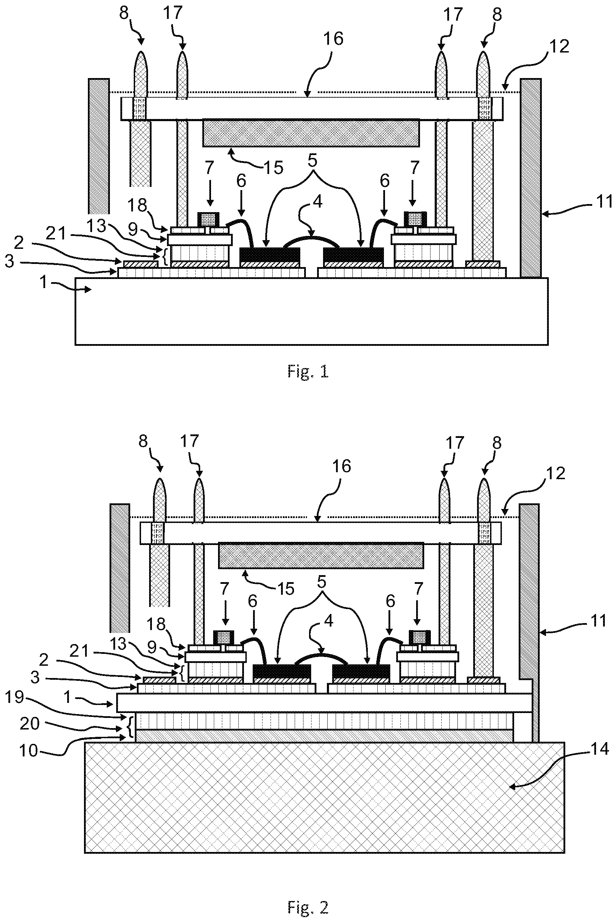

Fig. 1 shows the cross-section view on a power module of a fully solid-state circuit breaker. The power module for the solid-state circuit breaker includes insulating material 12. The insulating material 12 is placed in a package 11 made of a thermally resistant plastic. The insulating material 12 is a silicone dielectric gel.

In the insulating material 12 there is provided a bi-directional power electronics switch 5, non-power electronics circuits 7 including protective elements, circuits controlling the power electronics switch 5 and sensor circuits. Here, a desaturation protection is included in the protective elements. The sensor circuits are adapted to sensing of voltage, current, and temperature of the power electronics switch 5. In addition, the module includes a dielectric material heat sink 1 having thermal conductivity over 20 W/m/K. Aluminium nitride is suitable material for the heat sink 1. On its surface, the heat sink 1 is provided with an electrically conductive power pattern 3. An electrically conductive power pattern 3 comprises two electrically insulated sections. Owing to use of the dielectric material for the heat sink 1, the electrically conductive power pattern 3 is applied directly on the heat sink 1 and no electric insulation needs to be used between the electrically conductive power pattern 3 and the heat sink 1 being made of electrically conductive material in known designs.

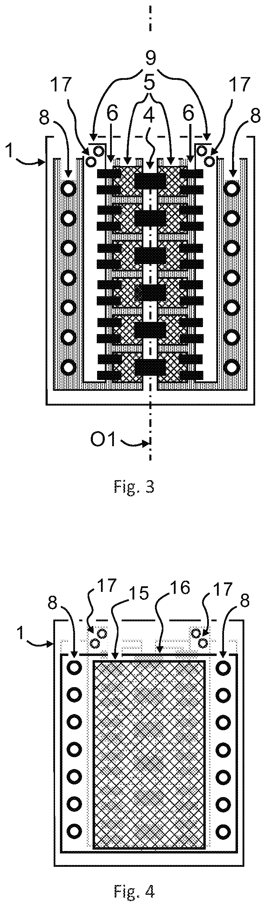

A bi-directional power electronics switch 5 is placed on the electrically conductive power pattern 3 and connected by an electrically conductive power connection 2. The bi-directional power electronics switch 5 comprises power semiconductor bare dies being mutually interconnected with a power conductive connection 4. The power electronics switch 5 is located on longitudinal axis O1 of the module. The power circuit comprises anti-serial arrangement of semiconductor bare dies of the power electronics switch 5. These are two groups of six of SiC MOSFET transistor dies connected in parallel, and they are placed axially symmetrically as closest as possible to the centre of the power module on the heat sink 1 as shown in Fig. 3

The electrically conductive power pattern 3 is interconnected with output power electric terminals 8. In addition, it is joined to the auxiliary dielectric substrates 9 via a contact layer 21. The contact layer 21 of the auxiliary dielectric substrate 9 comprises an electrically conductive layer 13 applied on the auxiliary dielectric substrate 9, and the electrically conductive power connection 2 of which full contact surfaces link the electrically conductive layer 13 and the electrically conductive power pattern 3 in a monolithic way. There are electrically conductive non-power patterns 18 placed on the auxiliary dielectric substrates 9. The non-power electric patterns 18 interconnect the non-power electronics circuits 7. The non-power electronics circuits 7 are interconnected with the output non-power electric terminals 17 and in addition, with the power electronics switch 5 via the non-power conductive connection 6. The heat sink 1, the power electronics switch 5, the auxiliary dielectric substrates 9, and the non-power electronics circuits 7 are jointly included in a monolithic multilayer structure elements of which are connected through entire contact surfaces.

Optimum control of the power electronics switch 5 bare dies arranged in parallel is provided by a suitable electric connection with the non-power electronics circuits 7. Thanks to thin layer of the electrically conductive non-power patterns 18 a necessary thin gap between the elements of the electrically conductive non-power pattern 18 is achieved allowing the use of the non-power electronics devices of SMD type with down to 0603 size. Here, the non-power electronics circuit 7 is used for symmetric and electrically identical driving of the transistors connected in parallel, for attenuation of undesired oscillations that occur by the power electronics circuit operation, or for protection of the gate electrodes of the transistors. Use of the auxiliary dielectric substrate 9 causes that a multilayer interconnection structure is formed. The structure allows full use of heat sink 1 obverse side to carry high current load by the electrically conductive power patterns 3 and axially symmetrical placement of the semiconductor bare dies of the power electronics switch 5 (refer to Fig. 3). At the same, the structure allows placement and interconnection of the non-power electronics circuit 7 on the auxiliary dielectric substrate 9 to be at distance as shortest as possible from the power electronics switch 5. The auxiliary dielectric substrates 9 have the quality of electric insulation, thermal expansion properties and thermal conductivity properties identical to the heat sink 1 and therefore, the resulting properties of the power module are not influenced in any way. In this example, balancing (protective) resistors of Gate and Source electrodes are placed on the auxiliary dielectric substrates 9 separately for each power semiconductor bare die. Use of the auxiliary dielectric substrate 9 permits maximization of the surface of the electrically conductive power pattern 3 on the heat sink 1. This is favourable, in particular with respect to minimization of the current density, minimization of power losses, and thermal impedance of the power module. At the same time, higher volume of the electrically conductive pattern 3 allow accumulation of more thermal energy in case of transient phenomena.

The output power electric terminals 8 and the output non-power electric terminals 17 are interconnected with the protective circuits 15 arranged on the substrate 16. The output terminals 8, 17 are provided as soldering pins.

The electrically conductive power pattern 3, the electrically conductive non-power patterns 18 and electrically conductive layer 13 of the auxiliary dielectric substrate 9 are applied by an additive technology (printing technique). As illustrated in Fig. 1, the electrically conductive power pattern 3 and the electrically conductive non-power patterns 18 have different thicknesses. The electrically conductive non-power pattern 18 is thinner than the electrically conductive power pattern 3. Thicknesses of the layers range from 20 µm to 300 µm.

The electrically conductive power connection 2 on the electrically conductive power pattern 3 and electrically conductive connection 10 of the auxiliary heat sink is a layer of solder. The power conductive connection 4 between the semiconductor bare dies of the bi-directional switch 5 and/or the non-power conductive connection 6 between the semiconductor bare dies of the bi-directional switch 5 and the non-power electronics circuit 7 are provided in the form of electrically conductive ribbons. More specifically, these are silver-plated copper ribbons. The power conductive connection 4 includes ribbons 4 mm wide and 200 µm thick. Compared to the wire-bonding technology, maximum transmitted current and reduction of the current density is permitted thereby not only in the power conductive connection 4 but also in the metallized area of the semiconductor bare die. The interconnection between the driving electrodes of the power electronics switch 5 bare dies and the non-power electronics circuit 7 is provided by 0.8 mm wide and 200 µm thick ribbons.

Another contemplated embodiment is shown in Fig. 2 and it differs from the one described above by that the dielectric material heat sink 1 is mechanically and thermally connected to the auxiliary heat sink 14 made of electrically conductive material having thermal conductivity over 180 W/m/K. A heat sink contact layer 20 is interconnecting the heat sink 1 and the auxiliary heat sink 14 while compensating their different thermal expansion properties. The contact layer 20 of the heat sink comprises an electrically conductive layer 19 applied on the heat sink 1, and an electrically conductive connection 10 of which full contact surfaces interconnect the electrically conductive layer 19 and the auxiliary heat sink 14 in a monolithic way. Here, the auxiliary heat sink 14 is made of aluminium, and the heat sink 1 is made of Al₂O₃. An advantage of this arrangement is lower price and lower demands on production technology.

### Industrial applicability

A power module of a solid-state circuit breaker finds its use in power applications in industry, services, or research and development, and where electricity is used with the need for safe operation.

### List of reference numerals

- 1: dielectric material heat sink
- 2: electrically conductive power connection
- 3: electrically conductive power pattern
- 4: power conductive connection
- 5: power electronics switch
- 6: non-power conductive connection
- 7: non-power electronics circuit
- 8: output power electric terminals
- 9: auxiliary dielectric substrate
- 10: electrically conductive connection of auxiliary heat sink
- 11: package
- 12: insulating material
- 13: electrically conductive layer of auxiliary dielectric substrate
- 14: auxiliary heat sink made of electrically conductive material
- 15: protective circuits
- 16: substrate
- 17: output non-power electric terminals
- 18: electrically conductive non-power pattern
- 19: electrically conductive layer of the heat sink
- 20: heat sink contact layer
- 21: auxiliary dielectric substrate contact layer

## Claims

1. A power module for a solid-state circuit breaker comprising an insulating material (12) in which there is arranged a bi-directional power electronics switch (5) and non-power electronics circuits (7) with protective elements, circuits controlling the power electronics switch (5) and sensor circuits,
further comprising a heat sink (1) made of a dielectric material having thermal conductivity over 20 W/m/K, having on its surface an electrically conductive power pattern (3) made of silver and/or copper, wherein the electrically conductive power pattern (3) comprises at least two electrically insulated sections,
the bi-directional power electronics switch (5) comprising power semiconductor bare dies mutually interconnected with a power conductive connection (4) is placed on the electrically conductive power pattern (3) and connected by the electrically conductive power connection (2), wherein the power electronics switch (5) is positioned on longitudinal axis (O1) of the module, the electrically conductive power pattern (3) is interconnected with output power electric terminals (8) and via a contact layer (21) further joined to auxiliary dielectric substrates (9) where there are electrically conductive non-power patterns (18) made of silver and/or copper interconnecting the non-power electronics circuits (7) placed on the auxiliary dielectric substrates (9), wherein said contact layer (21) of the auxiliary dielectric substrates (9) comprises an electrically conductive layer (13) applied on the auxiliary dielectric substrates (9), and the electrically conductive power connection (2) of which full contact surfaces interconnect the electrically conductive layer (13) and the electrically conductive power pattern (3) in a monolithic way,
the non-power electronics circuits (7) are interconnected with output non-power electric terminals (17) and with the power electronics switch (5) via a non-power conductive connection (6),
the output power electric terminals (8) and the output non-power electric terminals (17) are interconnected with protective circuits (15),
wherein at least the heat sink (1), the power electronics switch (5), the auxiliary dielectric substrates (9), and the non-power electronics circuits (7) are jointly included in a monolithic multilayer structure, which parts are connected through entire contact surfaces.

2. The power module according to claim 1 wherein the heat sink (1) is mechanically and thermally connected with an auxiliary heat sink (14) made of electrically conductive material having thermal conductivity over 180 W/m/K by a contact layer (20) to compensate different thermal expansion of the heat sink (1) and of the auxiliary heat sink (14).

3. The power module according to claim 2 wherein the contact layer (20) of the heat sink comprises an electrically conductive layer (19) applied on the heat sink (1), and an electrically conductive connection (10) of which full contact surfaces interconnect the electrically conductive layer (19) and the auxiliary heat sink (14) in a monolithic way.

4. The power module according to any of the previous claims wherein the heat sink (1) and/or auxiliary dielectric substrates (9) are made of ceramics.

5. The power module according to any of the previous claims wherein the power electronics switch (5) comprises bare dies of reverse conducting transistors arranged in anti-serial connection, or bare dies with reverse blocking transistors arranged in anti-parallel connection.

6. The power module according to any of the previous claims wherein the electrically conductive power connection (2) on the electrically conductive power pattern (3) and/or electrically conductive connection (10) of the auxiliary heat sink is a solder layer or a sintered material layer.

7. The power module according to any of the previous claims wherein the power conductive connection (4) between the power semiconductor bare dies of the bi-directional power electronics switch (5) and/or the non-power conductive connection (6) between the bare dies of the bi-directional power electronics switch (5) and the non-power electronics circuit (7) is provided in the form of aluminium and/or copper wires and/or electrically conductive ribbons.

8. The power module according to any of the previous claims wherein the insulating material (12) is placed in a package (11).

9. The power module according to any of the previous claims 1 to 7 wherein the insulating material (12) is self-supporting and is the package (11).

## Patentansprüche

1. Leistungsmodul für einen Halbleiter-Leistungsschutzschalter, das ein Isoliermaterial (12) umfasst, in dem ein bidirektionaler Leistungselektronik-Schalter (5) sowie nicht-leistungselektronische Schaltungen (7) mit Schutzelementen, Steuerkreisen für den Leistungselektronik-Schalter (5) und Sensorschaltungen angeordnet sind,
ferner einen Kühlkörper (1) aus einem dielektrischen Material mit einer Wärmeleitfähigkeit von über 20 W/m/K, auf dessen Oberfläche ein elektrisch leitfähiges Leistungsmuster (3) aus Silber und/oder Kupfer angeordnet ist, wobei das elektrisch leitfähige Leistungsmuster (3) mindestens zwei elektrisch isolierte Abschnitte umfasst,
wobei der bidirektionale Leistungselektronik-Schalter (5) Halbleiter-Chips in Form von Leistungshalbleitern umfasst, die durch eine leistungsleitende Verbindung (4) miteinander verbunden sind, und auf dem elektrisch leitfähigen Leistungsmuster (3) platziert sowie durch die elektrisch leitfähige Leistungsanschlussverbindung (2) verbunden ist, wobei der Leistungselektronik-Schalter (5) auf der Längsachse (O1) des Moduls positioniert ist, das elektrisch leitfähige Leistungsmuster (3) mit den elektrischen Ausgangsklemmen für die Leistung (8) verbunden ist und über eine Kontaktschicht (21) mit zusätzlichen dielektrischen Substraten (9) verbunden ist, auf denen elektrisch leitfähige nicht-leistungselektronische Muster (18) aus Silber und/oder Kupfer angeordnet sind, die die nicht-leistungselektronischen Schaltungen (7) auf den zusätzlichen dielektrischen Substraten (9) verbinden, wobei die genannte Kontaktschicht (21) der zusätzlichen dielektrischen Substrate (9) eine elektrisch leitfähige Schicht (13) umfasst, die auf die zusätzlichen dielektrischen Substrate (9) aufgebracht ist, und die elektrisch leitfähige Leistungsanschlussverbindung (2), deren vollständige Kontaktflächen die elektrisch leitfähige Schicht (13) und das elektrisch leitfähige Leistungsmuster (3) monolithisch verbinden,
die nicht-leistungselektronischen Schaltungen (7) mit den nicht-leistungselektrischen Ausgangsklemmen (17) und mit dem Leistungselektronik-Schalter (5) über eine nicht-leistungsleitende Verbindung (6) verbunden sind,
die elektrischen Ausgangsklemmen für die Leistung (8) und die nicht-leistungselektrischen Ausgangsklemmen (17) mit Schutzschaltungen (15) verbunden sind,
wobei mindestens der Kühlkörper (1), der Leistungselektronik-Schalter (5), die zusätzlichen dielektrischen Substrate (9) und die nicht-leistungselektronischen Schaltungen (7) gemeinsam in eine monolithische mehrschichtige Struktur integriert sind, deren Teile durch vollständige Kontaktflächen verbunden sind.

2. Leistungsmodul gemäß Anspruch 1, wobei der Kühlkörper (1) mechanisch und thermisch mit einem zusätzlichen Kühlkörper (14) aus elektrisch leitfähigem Material mit einer Wärmeleitfähigkeit von über 180 W/m/K durch eine Kontaktlage (20) verbunden ist, um unterschiedliche Wärmeausdehnungen des Kühlkörpers (1) und des zusätzlichen Kühlkörpers (14) auszugleichen.

3. Leistungsmodul gemäß Anspruch 2, wobei die Kontaktlage (20) des Kühlkörpers eine elektrisch leitfähige Schicht (19) umfasst, die auf den Kühlkörper (1) aufgebracht ist, sowie eine elektrisch leitfähige Verbindung (10), deren vollständige Kontaktflächen die elektrisch leitfähige Schicht (19) und den zusätzlichen Kühlkörper (14) monolithisch verbinden.

4. Leistungsmodul gemäß einem der vorhergehenden Ansprüche, wobei der Kühlkörper (1) und/oder die zusätzlichen dielektrischen Substrate (9) aus Keramik bestehen.

5. Leistungsmodul gemäß einem der vorhergehenden Ansprüche, wobei der Leistungselektronik-Schalter (5) aus blanken Chips von rückleitenden Transistoren besteht, die in einer Antiserienschaltung angeordnet sind, oder aus blanken Chips mit rücksperrenden Transistoren, die in einer Antiparallelschaltung angeordnet sind.

6. Leistungsmodul gemäß einem der vorhergehenden Ansprüche, wobei die elektrisch leitfähige Leistungsanschlussverbindung (2) auf dem elektrisch leitfähigen Leistungsmuster (3) und/oder die elektrisch leitfähige Verbindung (10) des zusätzlichen Kühlkörpers eine Lötverbindung oder eine gesinterte Materialschicht ist.

7. Leistungsmodul gemäß einem der vorhergehenden Ansprüche, wobei die leistungsleitende Verbindung (4) zwischen den Halbleiter-Chips des bidirektionalen Leistungselektronik-Schalters (5) und/oder die nicht leistungsleitende Verbindung (6) zwischen den Halbleiter-Chips des bidirektionalen Leistungselektronik-Schalters (5) und der nicht leistungselektronischen Schaltung (7) in Form von Aluminium- und/oder Kupferdrähten und/oder elektrisch leitfähigen Bändern ausgeführt ist.

8. Leistungsmodul gemäß einem der vorhergehenden Ansprüche, wobei das Isoliermaterial (12) in einem Gehäuse (11) untergebracht ist.

9. Leistungsmodul gemäß einem der Ansprüche 1 bis 7, wobei das Isoliermaterial (12) selbsttragend ist und das Gehäuse (11) bildet.

## Revendications

1. Un module de puissance pour un disjoncteur à semi-conducteurs comprenant un matériau isolant (12) dans lequel est disposé un interrupteur électronique de puissance bidirectionnel (5) et des circuits électroniques non liés à la puissance (7) avec des éléments de protection, des circuits de commande de l'interrupteur électronique de puissance (5) et des circuits de capteur,
comprenant en outre un dissipateur thermique (1) en matériau diélectrique ayant une conductivité thermique supérieure à 20 W/m/K, ayant à sa surface un motif conducteur de puissance (3) en argent et/ou en cuivre, ledit motif conducteur de puissance (3) comprenant au moins deux sections électriquement isolées,
l'interrupteur électronique de puissance bidirectionnel (5) comprend des puces semi-conductrices de puissance interconnectées par une connexion conductrice de puissance (4) et est placé sur le motif conducteur de puissance (3) et relié par la connexion conductrice de puissance (2), l'interrupteur électronique de puissance (5) étant positionné sur l'axe longitudinal (O1) du module,
le motif conducteur de puissance (3) étant interconnecté avec les bornes électriques de sortie de puissance (8) et via une couche de contact (21) reliée en outre à des substrats diélectriques auxiliaires (9) où se trouvent des motifs non conducteurs de puissance (18) en argent et/ou en cuivre interconnectant les circuits électroniques non liés à la puissance (7) placés sur les substrats diélectriques auxiliaires (9), ladite couche de contact (21) des substrats diélectriques auxiliaires (9) comprenant une couche conductrice électriquement (13) appliquée sur les substrats diélectriques auxiliaires (9), et la connexion conductrice de puissance (2) dont les surfaces de contact complètes interconnectent la couche conductrice électriquement (13) et le motif conducteur de puissance (3) de manière monolithique,
les circuits électroniques non liés à la puissance (7) étant interconnectés avec les bornes électriques de sortie non liées à la puissance (17) et avec l'interrupteur électronique de puissance (5) via une connexion conductrice non liée à la puissance (6),
les bornes électriques de sortie de puissance (8) et les bornes électriques de sortie non liées à la puissance (17) étant interconnectées avec des circuits de protection (15),
au moins le dissipateur thermique (1), l'interrupteur électronique de puissance (5), les substrats diélectriques auxiliaires (9) et les circuits électroniques non liés à la puissance (7) étant intégrés dans une structure monolithique multicouche, dont les parties sont reliées par l'ensemble des surfaces de contact.

2. Le module de puissance selon la revendication 1, dans lequel le dissipateur thermique (1) est mécaniquement et thermiquement connecté à un dissipateur thermique auxiliaire (14) en matériau électriquement conducteur ayant une conductivité thermique supérieure à 180 W/m/K, par une couche de contact (20) afin de compenser les différentes dilatations thermiques du dissipateur thermique (1) et du dissipateur thermique auxiliaire (14).

3. Le module de puissance selon la revendication 2, dans lequel la couche de contact (20) du dissipateur thermique comprend une couche électriquement conductrice (19) appliquée sur le dissipateur thermique (1), et une connexion électriquement conductrice (10) dont les surfaces de contact complètes interconnectent la couche électriquement conductrice (19) et le dissipateur thermique auxiliaire (14) de manière monolithique.

4. Le module de puissance selon l'une quelconque des revendications précédentes, dans lequel le dissipateur thermique (1) et/ou les substrats diélectriques auxiliaires (9) sont en céramique.

5. Le module de puissance selon l'une quelconque des revendications précédentes, dans lequel l'interrupteur électronique de puissance (5) comprend des puces nues de transistors à conduction inversée disposées en connexion anti-série, ou des puces nues avec des transistors à blocage inverse disposés en connexion anti-parallèle.

6. Le module de puissance selon l'une quelconque des revendications précédentes, dans lequel la connexion conductrice de puissance (2) sur le motif conducteur de puissance (3) et/ou la connexion électriquement conductrice (10) du dissipateur thermique auxiliaire est une couche de soudure ou une couche de matériau fritté.

7. Le module de puissance selon l'une quelconque des revendications précédentes, dans lequel la connexion conductrice de puissance (4) entre les puces nues de semi-conducteurs du commutateur de l'interrupteur électronique de puissance bidirectionnel (5) et/ou la connexion conductrice non liée à la puissance (6) entre les puces nues du commutateur de l'interrupteur électronique de puissance bidirectionnel (5) et le circuit électronique non-puissance (7) est réalisée sous forme de fils en aluminium et/ou en cuivre et/ou de rubans électriquement conducteurs.

8. Le module de puissance selon l'une quelconque des revendications précédentes, dans lequel le matériau isolant (12) est placé dans un boîtier (11).

9. Le module de puissance selon l'une quelconque des revendications 1 à 7, dans lequel le matériau isolant (12) est autoportant et constitue le boîtier (11).
